(19) Europäisches Patentamt
European Patent Office
Office européen des brevets

(11) EP 1 002 322 B1

(12) # EUROPÄISCHE PATENTSCHRIFT

(45) Veröffentlichungstag und Bekanntmachung des Hinweises auf die Patenterteilung:
**24.11.2004 Patentblatt 2004/48**

(21) Anmeldenummer: **98942622.6**

(22) Anmeldetag: **24.07.1998**

(51) Int Cl.7: **H01B 1/12**, C08G 73/02

(86) Internationale Anmeldenummer:
**PCT/EP1998/004660**

(87) Internationale Veröffentlichungsnummer:
**WO 1999/005687 (04.02.1999 Gazette 1999/05)**

(54) **CHEMISCHE VERBINDUNGEN VON INTRINSISCH LEITFÄHIGEN POLYMEREN MIT METALLEN**

CHEMICAL COMPOUNDS MADE OF INTRINSICALLY CONDUCTIVE POLYMERS AND METALS

COMPOSES CHIMIQUES CONSTITUES DE POLYMERES INTRINSEQUEMENT CONDUCTEURS ET DE METAUX

(84) Benannte Vertragsstaaten:
**AT BE CH DE FI FR GB IT LI NL SE**

(30) Priorität: **25.07.1997 DE 19732383**

(43) Veröffentlichungstag der Anmeldung:
**24.05.2000 Patentblatt 2000/21**

(73) Patentinhaber: **Ormecon GmbH
22949 Ammersbek (DE)**

(72) Erfinder: **WESSLING, Bernhard
D-22941 Bargteheide (DE)**

(74) Vertreter: **UEXKÜLL & STOLBERG
Patentanwälte
Beselerstrasse 4
22607 Hamburg (DE)**

(56) Entgegenhaltungen:
**WO-A-94/27297**

- **KINLEN P J ET AL: "Corrosion protection using polyaniline coating formulations" INTERNATIONAL CONFERENCE ON SCIENCE AND TECHNOLOGY OF SYNTHETIC METALS (ICSM '96), SNOWBIRD, UT, USA, 28 JULY-2 AUG. 1996, Bd. 85, Nr. 1-3, Seiten 1327-1332, XP002083652 ISSN 0379-6779, Synthetic Metals, 15 Feb. 1997, Elsevier, Switzerland**
- **PATENT ABSTRACTS OF JAPAN vol. 012, no. 128 (C-489), 20. April 1988 & JP 62 246926 A (TOYOTA CENTRAL RES & DEV LAB INC), 28. Oktober 1987**
- **CHEN S -A ET AL: "DOPING OF POLYANILINE VIA PSEUDOPROTONATION BY AN IONIC SALT" ADVANCED MATERIALS, Bd. 7, Nr. 5, 1. Mai 1995, Seiten 473-475, XP000533524**
- **SAUERLAND V ET AL: "A mass spectrometric investigation of polyaniline using photoionization" SYNTHETIC METALS, 30 SEPT. 1996, ELSEVIER, SWITZERLAND, Bd. 82, Nr. 3, Seiten 193-199, XP002083653 ISSN 0379-6779**
- **NEOH K G ET AL: "Structural dependence of polyanilines on reaction medium" SYNTH MET;SYNTHETIC METALS APR 15 1991, Bd. 40, Nr. 3, 15. April 1991, Seiten 341-354, XP002083654**
- **LACHKAR A ET AL: "Metallization of polythiophenes. IV. Interaction of vapor-deposited Cu and Ni with poly 3-(1,1,1,2,2,3,3,4,4,5,5,6,6-tridecafluoro nonyl)thio phene (P3TT)" SYNTHETIC METALS, 30 DEC. 1995, ELSEVIER, SWITZERLAND, Bd. 75, Nr. 3, Seiten 195-200, XP002083655 ISSN 0379-6779**
- **INOUE M B ET AL: "Complexation of electroconducting polypyrrole with copper" SYNTHETIC METALS, 1 SEPT. 1990, SWITZERLAND, Bd. 38, Nr. 2, Seiten 205-212, XP002083656 ISSN 0379-6779**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft chemische Verbindungen von intrinsisch leitfähigen Polyanilinen mit Metallen, deren Herstellung sowie Anwendungen dieser Verbindungen.

Verbindungen intrinsisch leitfähiger Polyaniline (poly-Phenylenaminen) mit Metallen wie nachstehend definiert sind bisher nicht bekannt.

Unter "konjugierten bzw. intrinsisch leitfähigen Polymeren", werden solche organischen Polymere und deren Derivate verstanden, die polykonjugierte Bindungssysteme (z.B. Doppelbindungen, aromatische bzw. heteroaromatische Ringe oder Dreifachbindungen) aufweisen. Beispiele für solche Polymere sind Polydiacetylen, Polyacetylen (PAc), Polypyrrol (PPy), Polyanilin (PAni), Polythiophen (PTh), Polyisothianaphthen (PITN), Polyphenylenvinylen, Polyheteroarylenvinylen (PArV), wobei die Heteroarylen-Gruppe z.B. Thiophen oder Pyrrol sein kann, Poly-p-phenylen (PpP), Polyphenylensulfid (PPS), Polyperinaphthalin (PPN), sowie deren Derivate (die z.B. aus substituierten Monomeren aufgebaut sind), deren Copolymere mit anderen Monomeren und deren physikalische Mischungen. Sie können in verschiedenen Zuständen vorliegen, die durch jeweils unterschiedliche Summenformeln beschrieben werden und durch (elektro-)chemische Reaktionen wie Oxidation, Reduktion, Säure-/Basereaktion oder Komplexbildung zumeist im wesentlichen reversibel ineinander überführt werden können. Diese Reaktionen werden in der Literatur gelegentlich auch als "Dotierung" bzw. "Kompensation" bezeichnet oder können als "Beladung" und "Entladung" analog zu den elektrochemischen Prozessen in Batterien angesehen werden. Zumindest einer der möglichen Zustände ist elektrisch sehr gut leitfähig, z.B. mit einer Leitfähigkeit von mehr als 1 S/cm (als reiner Stoff), so daß von intrinsisch leitfähigen Polymeren gesprochen werden kann.

Einen guten Überblick über bereits synthetisierte intrinsisch leitfähige Polymere, die erfindungsgemäß geeignet sind, findet man in Synthetic Metals, Hefte 17, 18 und 19 (1987) sowie Vol. 84-86 (1997).

Derartige leitfähige Polymere sind auch bereits bei der Metallisierung von Leiterplatten verwendet worden (siehe WO-A-97/20084). Auch im Korrosionsschutz haben sie Verwendung gefunden (siehe WO-A-95/00678)

Der Erfindung liegt die Aufgabe zugrunde, elektrisch leitfähige Verbindungen von Polyanilin bereitzustellen, deren Leitfähigkeit gegenüber pH-Änderungen unempfindlicher ist als die von konventionellen leitfähigen Polymeren und die bei ihrer Verwendung in der Herstellung von Leiterplatten oder im Korrosionsschutz gegenüber konventionellen leitfähigen Polymeren Vorteile zeigen.

Diese Aufgabe wird durch die Verbindungen gemäß den Ansprüchen 1 bis 5 gelöst. Die Erfindung bezieht sich ebenfalls auf das Verfahren nach den Ansprüchen 6 bis 8 und die Verwendung nach Anspruch 9.

Bei den erfindungsgemäßen Verbindungen handelt es sich um solche von intrinsisch leitfähigem Polyanilin mit Metallen. Verbindungen dieses Typs sind bisher nicht bekannt.

Es wurde gefunden, daß intrinsisch leitfähiges Polyanilin überraschenderweise echte chemische Verbindungen mit Metallen eingehen kann und die hergestellten Polymer-Metall-Verbindungen ebenfalls elektrisch leitfähig sind.

Aufgrund der durchgeführten Untersuchungen wird angenommen, daß die Verbindungen nach Art eines Copolymers der folgenden allgemeinen Formel (I) aufgebaut sind.

$$[\,(DU)_{a\cdot x}\,(Me^{a+})_x\,(DU_{ox}\,H^-)_y\,]\,(a\cdot x+y)\,A^- \qquad (I)$$

wobei

DU = eine Dimereinheit (dimer unit) des Polyanilins,
$DU_{ox}$ = eine oxidierte Form der Dimereinheit,
$Me^{a+}$ = ein Metallion der Wertigkeit a, wobei das Metallion Eisen, Kupfer, Magnesium oder Zinn ist
a = die Wertigkeit des Metallions,
x = eine ganze Zahl von 1 bis 10.000,
y = eine ganze Zahl von 0 bis 10.000,
$A^-$ = ein Anion

bedeutet.

Es wird weiter davon ausgegangen, daß das Metall chemisch an die Dimereinheit gebunden ist und daß jede Dimereinheit in der Lage ist, ein einwertiges Metallion zu binden. Für die Bindung eines zweiwertigen Metallions sind hingegen mindestens zwei Dimereinheiten erforderlich. Die Dimereinheiten können auch in dotierter Form vorliegen. Beispiele für Dimereinheiten DU sind für Polyanilin nachstehend angegeben.

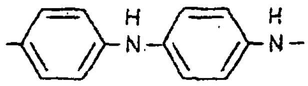

Als Anionen kommen insbesondere einwertige Anionen wie Chlorid, Toluolsulfonat oder Dodecylbenzolsulfonat, in Frage. Auch mehrwertige Anionen sind möglich, die dann jedoch in entsprechend geringerer Anzahl vorliegen.

Danach entsprechen bevorzugte Verbindungen von Polyanilin mit Eisen und Kupfer vermutlich den folgenden Formeln (II) und (III).

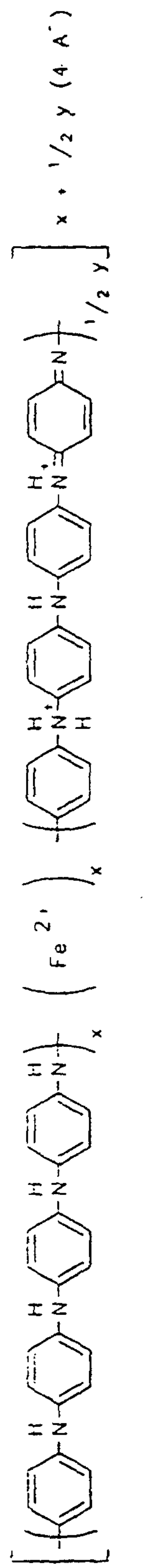

(II)

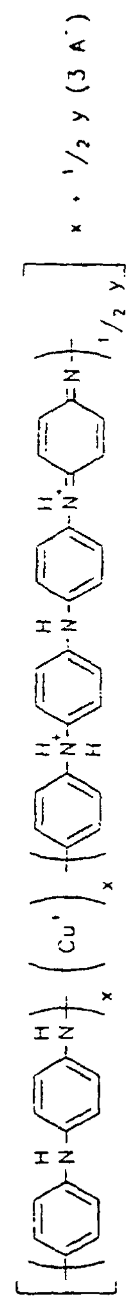

(III)

In den erfindungsgemäßen Verbindungen liegen die Metalle in der Regel als ein- oder mehrwertige positive Ionen vor, wobei die exakte Oxidationsstufe nicht wesentlich ist für die Erfindung, sondern von den Umgebungsbedingungen abhängt. Das Metall kann z.B. infolge interner Redoxreaktion mit dem Polymer auch die Oxiationsstufe Null

haben.

Als erfindungsgemäße Polymere sind allerdings solche ungeeignet, die nach dem Prinzip des "sish-kebap" aufgebaut sind, d.h. bei denen die elektronenreichen Monomereinheiten wie z.B. bei Polyphthalocyaninen aufeinander gestapelt ("stacked") sind.

Die Art der chemischen Bindung zwischen dem Metall und dem Polymer in den Verbindungen konnte bisher noch nicht aufgeklärt werden. Es könnte sich möglicherweise um eine Komplexbindung handeln. Jedenfalls sind stöchiometrisch definierte Verbindungen möglich mit einem Gehalt von knapp über Null bis zu 50 Mol-% eines einwertigen Ions, bis zu 25 Mol-% eines zweiwertigen Ions usw., bezogen auf Mole an Monomer in dem Polymer.

Bisher sind im Stand der Technik lediglich intrinsisch leitfähige Polymere bekannt, bei denen sich elektronenreiche Strukturelemente wie Doppelbindungen oder aromatische oder heteroaromatische Ringsysteme überlappen und die durch Protonierung mit Brönstedt-Säuren oder Oxidation mit Lewissäuren, d.h. durch eine sogenannte Dotierung, leitfähig gemacht werden. Es sind bisher jedoch keine Verbindungen bekannt, bei denen wie bei den erfindungsgemäßen Verbindungen chemische Bindungen zwischen dem Polymer und einem Metall wie nachstehend genannt vorliegen.

Die erfindungsgemäßen Verbindungen enthalten als Metall Eisen, Kupfer, Magnesium, Cadmium oder Zinn. Besonders bevorzugt sind dabei Eisen und Kupfer.

Das intrinsisch leitfähige Polymer ist Polyanilin.

Die erfindungsgemäßen Verbindungen liegen bevorzugt in Form von Dispersionen in wäßrigen oder organischen Dispersionsmitteln oder in Form von sie enthaltenden Lacken oder Polymerblends vor. Die Polymerblends enthalten neben den erfindungsgemäßen Verbindungen weitere Polymere, Copolymere oder Polymermischungen, wie z.B. Polyamide, Polyester, Polyether, wie Polyethylenoxide, Copolymer-Latices auf wäßriger Basis, wie z.B. Vinylacetatbutylacrylat, oder andere Copolymer-Latices, und/oder Polyvinylalkohole. Besonders bevorzugte weitere Polymere sind Polyamide.

Weiter sind Verbindungen von Polyanilin mit Kupfer oder Eisen bevorzugt, die als Dispersionen in N-Methylpyrrolidon und iso-Propanol bei spektroskopischer Untersuchung im UV-VIS-NIR-Bereich Absorptionsmaxima bei Wellenlängen von

- Kupfer-Polyanilin-Verbindung : 285 ± 5 nm,
- Eisen-Polyanilin-Verbindung : 280 ± 5 nm,

haben.

Die erfindungsgemäßen Metall-Polymer-Verbindungen können hergestellt werden, indem

(a) eine Dispersion von intrinsisch leitfähigem Polyanilin mit dem ausgewählten Metall in elementarer Form in Kontakt gebracht wird, wobei
(b) das Dispersionsmedium bewegt wird, um einen Stoffaustausch an der Grenzfläche zwischen Metall und Dispersion zu gewährleisten, und
(c) die Dispersion so lange mit dem Metall in Kontakt gebracht wird, bis sich die Metall-Polyanilin-Verbindung gebildet hat.

Zu (a) : Als Dispersionen kommen solche in Wasser oder wäßrigen Lösungsmitteln oder in organischen Lösungsmitteln in Frage. Geeignete Dispersionen sind z.B. in der WO-A-97/20084 und DE-C-38 34 526 beschrieben. Das Metall wird in elementarer Form, z.B. in Form von Folien, Platten oder Granalien, eingesetzt.

Zu (b) : Es ist wesentlich, daß das Dispersionsmedium bewegt wird, da es sonst lediglich zur Abscheidung von Schichten des leitfähigen Polymers auf dem Metall und nicht zur Bildung der erfindungsgemäßen Verbindungen kommt. Das Bewegen des Dispersionsmediums kann z.B. mittels üblicher Rührer oder auch durch Vorbeiströmen des Mediums an dem Metall erfolgen.

Zu (c) : Es hat sich gezeigt, daß ein kurzes Eintauchen des Metalles in eine Dispersion des ausgewählten Polymers nicht ausreicht, um die erfindungsgemäßen Verbindungen zu bilden. Vielmehr ist ein längerer Kontakt erforderlich. Die im Einzelfall erforderliche Dauer kann dadurch bestimmt werden, daß der Reaktionsverlauf z.B. durch UV-VIS-NIR-Spektroskopie verfolgt wird. Die Bildung von Metall-Polymer-Verbindung wird dabei durch eine stetige Veränderung des Spektrums angezeigt. Eine vollständige Reaktionen unter den gewählten Bedingungen ist dann erreicht, wenn sich im Spektrum keine weiteren Änderungen feststellen lassen.

In der Regel wird der Kontakt zwischen Metall und Polymerdispersion über eine Zeitraum von 0,1 bis 10.000 min und bevorzugt 1 bis 1.000 min durchgeführt.

An die Stufe (c) kann sich gegebenenfalls ein weiterer Schritt anschließen, mit dem die gebildete Metall-Polymer-Verbindung aus der Dispersion abgetrennt wird. Hierzu kann die Dispersion beispielsweise filtriert und die abfiltrierte Metall-Polymerverbindung gewaschen und getrocknet werden.

Weiter können die erfindungsgemäßen Verbindungen auch dadurch hergestellt werden, indem eine Dispersion einer reduzierten Form des intrinsisch leitfähigen Polyanilin mit Ionen des ausgewählten Metalles in Kontakt gebracht wird. Zur Herstellung der reduzierten Form kann das Polyanilin z.B. mit Natriumborhydrid umgesetzt werden.

Der Reaktionsverlauf kann dabei wiederum z.B. spektroskopisch verfolgt werden, und nach Abschluß der Reaktion kann die gebildete Metall-Polyanilin-Verbindung in der oben beschriebenen Weise abgetrennt werden.

Die weiteren Untersuchungen der Bildung der Metall-Polymer-Verbindungen führten zu der Annahme, daß es auch bei Variation der Reaktionsbedingungen offenbar stets zu einem Elektronenübergang zwischen dem leitfähigen Polymer und dem Metall und somit zu einer Redoxreaktion zwischen diesen Ausgangsmaterialien kommt. Durch Veränderung der Reaktionsbedingungen können im Einzelfall Verbindungen erhalten werden, die sich z.B. durch andere Gehalte an gebundenem Metall auszeichnen. So kann z.B. der Gehalt an Metall über die Dauer des Kontaktes mit der Dispersion sowie das Ausmaß der Bewegung des Dispersionsmediums beeinflußt werden. Dabei werden mit längerer Reaktionsdauer und stärkerer Bewegung höhere Metallgehalte in den hergestellten Verbindungen erzielt.

Eine nähere Untersuchung des Reaktionsvorgangs bei der Herstellung der erfindungsgemäßen Metall-Polymer-Verbindungen erfolgte, indem man eine Dispersion von Polyanilin in einem Gemisch aus N-Methylpyrrolidon (NMP) und iso-Propanol, wie sie in der DE-C-38 34 526 offenbart ist, mit Metallstücken aus Kupfer und Eisen versetzte und diese unter stetigem Rühren regelmäßig spektroskopisch untersuchte (Beispiel 1). Es ergaben sich dabei die als Fig. 1 und 2 bezeichneten Spektren der Ausgangsmischung sowie der im Verlauf der Reaktionen aufgenommenen veränderten Spektren. In Fig. 3 sind das Ausgangsspektrum sowie die Endspektren übereinander gelagert, um die aufgetretenen Veränderungen zu verdeutlichen.

Dabei ist bemerkenswert, daß jede Metall-Polyanilin-Verbindung ein anderes Spektrum ergab. Das legt die Annahme nahe, daß jede Verbindung eine andere Struktur hat und andere Wechselwirkungen zwischen den Elektronen des Polyanilins und des Metalls auftreten. Die kontinuierliche Veränderung der Spektren zeigte den Reaktionsverlauf, d.h. die Bildung der neuen chemischen Verbindungen an.

Die Veränderung der Spektren folgte bei allen Reaktionen einem einheitlichen Muster. Die Intensität der Bande des Polyanilins bei etwa 800 nm nahm in allen Fällen ab. Im Falle der Fe-Verbindung wurde das Maximum der Bande zu höheren Wellenlängen verschoben, im Falle des Kupfers zu niedrigeren Wellenlängen.

Die Bande bei ca. 430 nm nahm ebenfalls in allen Fällen an Intensität ab, im Falle des Fe wiederum schwächer als bei Cu.

Die Bande bei ca. 325 nm sowie die Schulter bei 280 nm wurden in allen Fällen verstärkt. In allen Fällen zeigten sich klare isosbestische Punkte. Bei Fe bildete sich ein neues Absorptionsmaximum bei 280 nm mit einer Schulter bei 320 nm, bei Cu ein sehr starkes Maximum (stärker als bei Fe) bei ca. 282 nm (keine Feinstruktur).

Zum Vergleich untersuchte Mischungen von Dispersionen von reinen leitfähigen Polymeren mit Ionen des entsprechenden Metalls ergaben Spektren, die denen der reinen Polymere entsprachen und sich somit signifikant von den Spektren der erfindungsgemäßen Verbindungen unterschieden. Dies ist ein weiterer Beleg für die Bildung der Metall-Polyanilin-Verbindungen.

In einem anderen Experiment (Beispiel 2) wurden die Reaktionen von Metallen in einer wäßrigen Dispersion von Polyanilin ausgeführt. Für die einzelnen Metalle wurden nach Beendigung der Reaktion die in der Tabelle 1 zu Beispiel 2 angegebenen Konzentrationen in der Dispersion gefunden. Nach Ausflockung des dispergierten Polyanilins wurde eine deutlich niedrigere Menge an Metallionen in Lösung gefunden, was belegt, daß der überwiegende Teil im Polyanilin gebunden vorliegt.

Weiter zeigt Tabelle 2 zu Beispiel 2 ein merkwürdiges Verhalten, das noch nicht ganz verstanden ist. Spalten (A), (B) und (C) zeigen den pH-Wert der wäßrigen Polyanilin-Dispersion (Ausgangswert: 3,2) (A) nach der Reaktion, (B) nach Verdünnung der Dispersion (1:20 zum Zwecke der spektroskopischen Untersuchung) und (C) nach Stehenlassen über einen Monat hinweg. Zunächst fällt auf, daß bei einigen Metallen, nämlich Sn und Fe unter (A) keine oder fast keine pH-Änderung gegenüber dem Ausgangswert zu verzeichnen ist. Bei anderen Metallen wie Cu tritt eine deutliche pH-Steigerung und bei Cd und Mg sogar eine deutliche Änderung zu pH-Werten von mehr als 7 auf.

Bei der Verdünnung in Wasser ergibt sich der erwartete Effekt (B), nicht so jedoch beim Stehenlassen über einen Monat (C). Einige Dispersionen blieben pH-stabil, andere zeigten einen steigenden und wiederum andere einen fallenden pH-Wert.

Es ist bekannt, daß reines Polyanilin bei einem pH-Wert von 3,5 bis 4 einen Farbwechsel von Grün nach Blau zeigt und somit bei höheren pH-Werten ein blaue Farbe hat. Demgegenüber zeigen die erhaltenen Verbindungen völlig überraschende Farben. Die Cu-Verbindung ist schon bei pH 5-6 und die Mg-Verbindung bei pH 7-10 blau. Die Cd-Verbindung ist ebenfalls grün, obwohl sie einen pH von teilweise mehr als 7 bewirkte.

Die pH-Änderungen, die generell in Richtung eines höheren pH tendieren, sind mit Ausnahme von Mg, wo als Nebenreaktion eine Wasserstoffentwicklung auftritt, derzeit ebenfalls nicht verstanden. Wenn man annähme, daß das Metall bei der Bindung an das Polymer entsprechende Protonen ersetzen würde, so müßten diese frei werden und den pH-Wert senken. Dies ist offenbar jedoch nicht der Fall. Stattdessen werden Protonen offenbar verbraucht, wie die Steigerung des pH-Wertes zeigt. Dieses Verhalten könnte unter der Annahme erklärt werden, daß es bei der

Ausbildung der erfindungsgemäßen Verbindungen zu einem echten Elektronenaustausch zwischen dem Metall und dem Polyanilin kommt, wodurch letzteres zu Leucoemeraldin reduziert wird. Dieser Vorgang könnte. somit für die Bildung der neuen Verbindungsklasse charakteristisch sein.

Die erfindungsgemäßen Verbindungen zeichnen sich weiter dadurch aus, daß aus ihnen das Metall nicht extrahiert werden kann. So konnte z.B. nach Suspendierung von Eisen-Polyanilin-Verbindung in Wasser und Abtrennen der Verbindung nahezu kein Eisen im Wasser nachgewiesen werden.

Für industrielle Maßstäbe eignet sich besonders die in Beispiel 3 beschriebene Herstellung der erfindungsgemäßen Metall-Polyanilin-Verbindungen. Es hat sich auch gezeigt, daß man nicht unbedingt in allen Fällen ein Verbindung benötigt, die die maximal bindbare Menge an Metall enthält. In vielen Fällen sind Verbindungen, die eine geringere Menge enthalten, ausreichend.

Die weiteren Untersuchungen zeigten, daß die hergestellten erfindungsgemäßen Verbindungen im Rahmen der Meßgenauigkeit wie das vergleichbare metallfreie Polyanilin leitfähig und auch vergleichbar gut dispergierbar sind (siehe Tabelle 3 zu Beispiel 3).

Die Metallverbindungen haben überdies interessante, für die praktische Anwendung bedeutsame Eigenschaften. Sie können z.B. als elektrische Leiter oder als Komponente von antistatischen oder leitfähigen Beschichtungen eingesetzt werden. Weiter können sie unter anderem bei der Abschirmung von elektromagnetischen Wellen (EMI-Abschirmung) oder dem Schutz vor statischen Aufladungen z. B. als Folien verwendet werden. Weiter können aus ihnen elektrische Bauelementen und Sensoren hergestellt werden. Bei allen diesen Anwendungen werden die Metall-Polyanilin-Verbindungen in üblicher Weise wie die entsprechenden leitfähigen Polymere eingesetzt. In der Regel werden sie daher nach einer etwaigen Überführung in einen Polymerblend in geeigneter Weise verformt und zu den gewünschten Gegenständen, wie Folien oder elektrischen Leitern oder Bauelementen, verarbeitet oder sie werden in geeignete Zusammensetzungen eingearbeitet, um z.B. Beschichtungsmassen zu erhalten, die dann in üblicher Weise weiterverarbeitet werden.

Die Erfindung betrifft insbesondere die Verwendung der erfindungsgemäßen Verbindungen bei der Metallisierung von Substraten, bei der Herstellung von elektrischen Leiterplatten und beim Schutz metallischer Gegenstände vor Korrosion. Dabei wird bei der Metallisierung die Verbindung auf das ausgewählte Substrat aufgebracht und danach wird das beschichtete Substrat mit Metallisierungslösung in Kontakt gebracht, um die Metallabscheidung zu erzielen. Bei der Herstellung elektrischer Leiterplatten wird die erfindungsgemäße Verbindung ebenfalls als Vorbehandlung auf die Leiterplatte aufgebracht und die Leiterplatte wird dann in üblicher Weise metallisiert, insbesondere verzinnt. Besonders geeignet ist in diesem Zusammenhang die Verwendung von Kupfer-Polyanilin-Verbindung, die zu einer ausgezeichneten Lötfähigkeit bei den hergestellten Leiterplatten führt. Beim Korrosionsschutz werden Zusammensetzungen mit Gehalt an erfindungsgemäßer Verbindung, wie z.B. Lacke, auf den zu schützenden metallischen Gegenstand aufgebracht. Hieran können sich übliche weitere Schritte zum Korrosionschutz anschließen (siehe insbesondere WO-A-95/00678).

In all diesen Fällen werden vorzugsweise Suspensionen der erfindungsgemäßen Verbindungen eingesetzt.

Weiter führt beispielsweise eine vor der chemischen Zinnabscheidung aus entsprechenden Zinn-Bädern erfolgende Vorbehandlung von Leiterplatten mit einer wäßrigen Dispersion der erfindungsgemäßen Cu-Polyanilin-Verbindung zu einer Lötfähigkeit der Leiterplatten über einen sehr weiten Bereich der Zinnkonzentration, wie Figur 5 zu Beispiel 4 zeigt. Eine Cu-freie übliche Polyanilin-Dispersion führt demgegenüber in der Praxis zu Unregelmäßigkeiten und nicht reproduzierbaren Lötergebnissen und ab Konzentrationen von 0,02 mol Cu/Liter Zinnbad zu nicht lötfähigen Zinn-Endoberflächen. Bei Verwendung einer konventionellen Polyanilin-Dispersion entsprechend WO 97/20084 als Vorbehandlung vor der chemischen Zinnabscheidung ergibt sich zwar eine Verbesserung gegenüber konventionellen chemischen Zinnabscheidungsverfahren ohne Vorbehandlung mit leitfähigen Polymeren, die Lötfähigkeit ist aber unterhalb 20 g Zinn/Liter Zinnbad nicht mehr gegeben. Das Cu:Sn-Verhältnis beträgt höchstens nur 1,6:1, obwohl für 100%ige Lötfähigkeit über den gesamten Bereich der Sn- und Cu-Konzentration hinweg ein Verhältnis von größer oder gleich 2,0:1 erforderlich ist.

Weiter können Korrosionsschutzverfahren deutlich schneller und reproduzierbarer durchgeführt werden, wenn man Zusammensetzungen einsetzt, die erfindungsgemäße Verbindungen und bevorzugt eine Fe-Polyanilin-Verbindung anstelle von konventionellem metallfreien Polyanilin enthalten. Für diese Zwecke reicht bereits ein 0,05 - 0,4 % Gewichtsprozent Fe enthaltendes Polyanilin (dies entspricht etwa 15 Fe-Ionen pro Primärpartikel). Ein bevorzugtes Korrosionsschutzverfahren ist in der WO 95/00678 beschrieben, dessen gesamte Offenbarung durch Bezugnahme in diese Anmeldung aufgenommen wird.

Diese Vorzüge gelten insbesondere für polyanilin-haltige Lacke auf wäßriger Basis. Hier haben wäßrige Lacke eher den Nachteil, daß sie beim Auftragen und Trocknen Korrosionsprozesse in Gang setzen, anstatt diese zu verhindern. Dies ist daran erkennbar, daß sich während des Trockenvorganges des auf eisenhaltigen Werkstoffen aufgebrachten Lacks Rost bildet. Verwendet man hingegen insbesondere eine erfindungsgemäße Fe-Polyanilin-Verbindung, so wird diese Rostbildung nicht beobachtet.

Schließlich ist der Korrosionschutz von Leichtmetallen, wie Mg und seinen Legierungen, mit intrinsisch leitfähigen Polymeren, wie Polyanilin, nicht oder nur schlecht möglich. Verwendet man hingegen z.B. eine Mg-Polyanilin-Verbindung, so erreicht man eine ausgezeichnete Passivität gegenüber korrosiven Medien, wie die Durchführung eines Salzsprühtest nach DIN 50021 an der deutlich verminderten Bildung von weißen Mg-Korrosionsprodukten, wie vornehmlich Magnesiumoxiden und -hydroxiden, zeigt.

Polyanilin ist im übrigen bekannt dafür, daß es seine Leitfähigkeit mit dem pH-Wert des umgebenden Mediums ändert. Bei einem pH von 7 beispielsweise hat es seine Leitfähigkeit, wenn dünne Filme gemessen werden, komplett verloren und weist z.B. nur noch $10^{-9}$ S/cm auf. Die erfindungsgemäßen Metall-Polyanilin-Verbindungen besitzen die Eigenschaft, gegenüber einer pH-Änderung wesentlich langsamer zu reagieren. So haben Pulver von Eisen-Polyanilin-Verbindungen eine Ausgangsleitfähigkeit (als Preßling) von z.B. 5 S/cm. Nach einer Suspendierung in wäßrigen Medien bei pH-Werten von 3, 7 bzw. 9 und anschließender Trocknung ergeben sich Leitfähigkeiten von 0,034, 0,032 bzw. 0,004 S/cm. Polyanilin-Pulver wies demgegenüber bei pH 7 beispielsweise nur eine Leitfähigkeit von 0,0004 S/cm auf, d.h. die Leitfähigkeit ist um einen Faktor von etwa 100 geringer.

Die Erfindung wird im folgenden anhand von Beispielen näher erläutert.

**Beispiele:**

**Beispiel 1**

Eine kolloidale Dispersion von Polyanilin in organischen Lösungsmitteln, erhältlich als ORMECON® 900132 von Ormecon Chemie, Deutschland, wurde zunächst im Verhältnis 1:10 mit iso-Propanol verdünnt und in einer Quarzglasküvette (für Spektroskopie) im UV-VIS-NR-Bereich spektroskopisch untersucht. Das erhaltene Absorptionsspektrum ist in Fig. 3 mit "ORMECON® 900132" bezeichnet.

Anschließend wurden entsprechende Dispersionen angesetzt und mit den Metallen Fe und Cu in Form von Streifen unter stetigem Rühren versetzt. Es wurden regelmäßig Proben entnommen und spektroskopisch untersucht. Es ergaben sich die in Figur 1 für Kupfer und Figur 2 für Eisen erhaltenen Spektren, wobei in den Figuren jeweils mit o das Ausgangsspektrum und mit x das Endspektrum bezeichnet ist. Es wurden alle 5 Minuten Spektren aufgenommen, und nach etwas mehr als 1 Stunde war keine Veränderung mehr erkennbar, was das Ende der Reaktion und den Erhalt des Endspektrums anzeigte. Zur Verdeutlichung der aufgetretenen Veränderungen zeigt Figur 3 das Ausgangsspektrum für ORMECON® 900132 und die resultierenden Endspektren für die verschiedenen Metall-Polyanilin-Verbindungen, wobei "Pani" für Polyanilin steht.

**Beispiel 2**

Eine wäßrige Dispersion von Polyanilin, die 0,013 Mol p-Toluolsulfonsäure enthält und als ORMECON® PCB 7000 von Ormecon Chemie, Deutschland, erhältlich ist, wurde im Verhältnis 1:20 mit Wasser verdünnt und 12 h lang mit Platten oder Granalien verschiedener Metalle versetzt. In den resultierenden Dispersionen wurden die Metallgehalte teilweise mittels Plasma-Atomemissionsspektralanalyse untersucht. Von den erhaltenen Konzentrationen wurde der für das jeweilige Metall ermittelte Basiswert gemäß Tabelle 1 abgezogen, um ein bessere Aussage über den Metallgehalt der erzeugten Verbindungen machen zu können, und die erhaltenen korrigierten Werte sind in der Tabelle 2 unter "AE" angegeben.

Für einen Vergleich dieser Werte mit nach naßchemischen Methoden gewonnenen Daten wurden nach Beendigung der Reaktion bei Cu und Fe getrennt voneinander die folgenden Schritte durchgeführt

(a) Ausflocken der Dispersion mit NaCl, Abfiltrieren und quantitative Bestimmung des Metallgehalts in dem Filtrat durch Titration mit wäßriger Dinatrium-Ethylendiamintetraessigsäure-Lösung (Titriplex (III) von Merck, Deutschland), wobei als Indikatoren für Eisen 5-Sulfosalicylsäure, für Kupfer 4-(2-Pyridylazo)-resorcin, für Zinn Xylenolorange und für Eisen eine Indikator-Puffer-Tablette von Merck, Deutschland, eingesetzt wurden.

(b) Zum Vergleich wurde ein oxidativer Aufschluß der gesamten Dispersion mittels $HNO_3$ und eine quantitative Bestimmung des Metallgehaltes in der erhaltenen Mischung, wie bei (a) beschrieben, durchgeführt.

Schließlich wurde nach Beendigung der Reaktionen der "Basiswert", d.h. der Grad der Auflösung von Metall bestimmt, welcher alleinig durch Kontakt mit der in der Dispersion vorhandenen p-Toluolsulfonsäure herrührt. Hierzu wurde

(c) eine wäßrige 0,013 molare Lösung von p-Toluolsulfonsäure mit den Metallen versetzt, und der resultierende Gehalt der Lösung an Metall wurde wie bei (a) und mittels Atomemissionsspektralanalyse bestimmt.

Die nach (a), (b) und (c) bestimmten Metallkonzentrationen sind in Tabelle 1 aufgeführt. Die naßchemisch nach (b) ermittelte Konzentration setzt sich aus dem Basiswert und dem im Polyanilin gebundenen Metall zusammen. Der gegenüber dem Basiswert deutlich höhere Wert zeigt im übrigen, daß im Vergleich zu der durch die vorhandene Säure erfolgenden Metallablösung überwiegend eine chemische Reaktion zwischen Polyanilin und dem Metall erfolgt. Die ebenfalls naßchemisch nach (a) bestimmten Werte belegen, daß nicht wesentlich mehr Metall als bei der Basiswert-Ermittlung in Lösung geht.

Tabelle 1

| Metall | Konz. nach Ausflocken mit NaCl (mg/l) (naßchemisch) | Konz. nach oxidativem Aufschluß (mg/l) (naßchemisch) | Basiswert (mg/l) | |
|---|---|---|---|---|
| | | | AE | Naßchemisch |
| Cu | 38,13 (± 3,81) | 50,9 (± 5) | 24.34 | 28,8 |
| Fe | 9,05 (± 0,3) | 61,3 (± 2,15) | 14,71 | 27,8 |
| Mg | - | - | 32.6 | 25,4 |

In der nachstehenden Tabelle 2 sind unter "AE" und "naßchemisch" die jeweils gefundenen Nettowerte angegeben, die durch Abzug der Basiswerte von den Bruttokonzentrationen erhalten wurden.

Die Resultate der Atomemissionsspektralanalyse "AE" zeigen eine gute Übereinstimmung mit den naßchemisch ermittelten Ergebnissen.

Weiter sind in Tabelle 2 der prozentuale Gehalt in Gew.-% an Metall bestimmt auf naßchemischem Wege oder mittels Plasma-Atomemisionsspektralanalyse "AE", die errechnete Anzahl an Dimeren pro Metallion, die Farben der erhaltenen Dispersionen der Metall-Polymer-Verbindungen nach Beendigung der Reaktion und nach einem Monat sowie unter (A), (B) und (C) die pH-Werte der wäßrigen Polyanilin-Dispersion (Ausgangswert: 3,2) (A) nach der Reaktion, (B) nach Verdünnung der Dispersion (1:20 zum Zwecke der spektroskopischen Untersuchung) und (C) nach Stehenlassen über einen-Monat hinweg angegeben.

Tabelle 2

| Probe | AE (mg/l) | naßchemisch (mg/l) | % Metall in Polyanilin AE/naßchemisch | Dimere pro Metallion | Farbe nach Reaktion | (A) pH | (B) pH (1:20) | (C) nach 1 Monat | Farbe nach 1 Monat |
|---|---|---|---|---|---|---|---|---|---|
| Kupfer | 22,73 | 22,1 | 42 / 41 | 0,25 | blau | 5,3 | 5,7 | 6,0 | blau |
| Eisen | 46,15 | 33,5 | 85 / 62 | 0,1 | grün | 3,1 | 5,1 | 5,8 | grün |
| Magnesium | 12,76 | 12,1 | 24 / 22 | 0,22 | blau-violett | 9,7 | 8,7 | 6,8 | grün |
| Zinn | - | - | - | - | gelbgrün | 3,2 | 4,9 | 4,9 | gelbgrün |
| Cadmium | - | - | - | - | gelbgrün | 7,3 | 7,2 | 6,4 | gelbgrün |
| Ormecon PCB 7000 | - | - | - | - | - | 3,2 | 5,0 | 5,4 | - |

* fällt sehr schnell ab nach dem Verdünnen

**Beispiel 3**

Polyanilin wurde gemäß den in der WO 89/02155 beschriebenen Verfahrensweisen hergestellt. Die fertige Reaktions-Suspension wurde nach dem Aufwärmen aber noch nicht filtriert, sondern in mehrere Proben aufgeteilt. In diese Proben wurden jeweils Kupfer-, Eisen-, und Magnesium-Platten eingehängt. Nach 12 h unter stetigem Rühren hatte sich das Gewicht der Metall-Platten wie aus der nachstehenden Tabelle 3 ersichtlich verringert. Die erhaltenen Suspensionen wurden danach filtriert und wie in der WO-A-89/02155 und der US-A-5,281,363 beschrieben aufgearbeitet. Dabei wurde mehrmals mit Wasser und p-Toluolsulfonsäure-Lösung gewaschen und anschließend getrocknet. Die Filtrate und die nach insgesamt 4 Waschungen erhaltenen kombinierten Waschwässer wurden auf ihren Metallgehalt hin naßchemisch analysiert; die gefundenen Gehalte sind in Tabelle 3 angegeben. Die resultierenden, trockenen Pulver wurden elementaranalytisch charakterisiert und auf ihre Leitfähigkeit untersucht (siehe Tabelle 3). Ein Vergleich des absoluten Gewichtsverlusts an Metall mit der absoluten Menge des im isolierten trockenen Pulvers gebundenen Metalls und der Absolut-Menge des in Filtraten/Waschwässern nicht gebundenen Teils des aufgelösten Metalls ergab die in Tabelle 3 angegebene "Abweichung".

Tabelle 3

| Metall | Gewichtsverlust [g] | Metall in Lösung [g] | Trockenmasse PAni [g] | Metall gebunden [%, g], Elementaranalyse | Abweichung (%) | Metall gebunden* [g] | Anzahl Dimere pro Metallion* | Leitfähigkeit (S/cm) |
|---|---|---|---|---|---|---|---|---|
| Kupfer | 10,6 | 7,6 | 217 | 1,24 / 2,7 | 2,55 | 3 | 12 | 5 |
| Eisen | 32,2 | 14,6 | 210 | 0,05 / 0,1 | 54,3 | 17,6 | 2 | 5 |
| Magnesium | 39,8 | 37,7 | 116 | 0,24 / 0,09 | 7 | 2,2 | 3,6 | 3 |

* Hypothetische Werte unter der Annahme, daß das nicht in den Lösungen befindliche Metall in Polyanilin gebunden ist

- Trockenmasse PAni: Masse des eingesetzten Polyanilins

Hiernach ergeben sich für alle Metalle außer Eisen gute Bilanzen, d.h. es kann innerhalb eines akzeptablen Fehlers (angesichts der zahlreichen potentiellen Verluste bei den Waschungen und Filtrationen) die abreagierte Metallmenge entweder in Lösung oder gebunden im Pulver gefunden werden. Trotz zahlreicher Wiederholungen blieb bei Eisen jedoch eine Diskrepanz. Da die Analyse des Eisens in Lösung unproblematisch ist, scheint die Bindung an das Polyanilin so stark ist, daß flüchtige Oligomerverbindungen gebildet werden und damit bei der pyrolytischen Probevorbereitung Fe-Anteile der Analyse entzogen werden. Hierzu gibt es entsprechende Beobachtungen.

**Beispiel 4**

Es wurden Leiterplatten, die eine Teststruktur aufwiesen und bis zur Stufe des gehärteten Lötstoplacks gefertigt waren, auf 3 verschiedene Arten behandelt:

1. Ätzen; Spülen; chemisches Verzinnen mit einem Zinnbad auf Basis von Zinn-Salzen, Methansulfonsäure und Thioharnstoff, erhältlich als UNIKRON OA8 von der Firma Cimatech, Deutschland.

2. Ätzen; Spülen; 1 minütige Vorbehandlung mit einer wäßrigen Dispersion von Polyanilin, erhältlich als ORMECON® PCB 7000 von Ormecon Chemie, Deutschland; Spülen; Verzinnen mit UNIKRON OA8.

3. Ätzen; Spülen; Vorbehandlung mit einer wäßrigen Dispersion von Cu-Polyanilin-Verbindung, die durch Umsetzung von einer wäßrige Dispersion ORMECON® PCB 7000 mit Cu für 16 h gemäß Beispiel 2 hergestellt wurde; Spülen; Verzinnen mit UNIKRON OA8.

In allen 3 Versuchsreihen wurden soviele Platten verarbeitet, bis 1 $m^2$ Cu/l UNIKRON OA8 behandelt war. Die Cu- und Sn-Konzentrationen wurden bestimmt und graphisch gegen die verzinnte Kupferoberfläche pro 1 Verzinnungsbad aufgetragen.

Die erhaltenen Kurven für die Versuchsreihen 1 und 2 sind praktisch identisch und in der Figur 4 dargestellt. Sie zeigen eine nicht-lineare Entwicklung der Cu- und Sn-Konzentrationen. Die Lötfähigkeit (nach Alterung 4 h/155 °C, 3mal Umschmelzen im reflow-Ofen, Löttest auf der Lötwelle und Beurteilung nach IPC-A 600 C-D) ist praktisch ab 0,25 $m^2$ Cu/l Bad (= 0,03 mol Cu bzw. 0,015 mol Sn/l) nicht mehr gegeben. Das Molverhältnis Cu:Sn beträgt anfänglich 1:1 und verändert sich dann nicht-linear bis auf über 2,5:1.

Demgegenüber war bei der Versuchsreihe 3 mit erfindungsgemäßer Cu-Polyanilin-Verbindung ein völlig anderes Verhalten feststellbar, wie Figur 5 zeigt. Bei ihr erfolgte eine lineare Veränderung der Cu- und Sn-Konzentrationen über den gesamten Bereich mit einem Verhältnis Cu:Sn von 2,2:1, was praktisch dem Idealwert von 2:1 und damit einer Bruttoreaktion 2 Cu° + $5n^{2+}$ -> Sn° + 2 $Cu^+$ entspricht. Bis zu einer Verzinnung von 1 $m^2$ Cu/l Zinnbad und darüber hinaus (also bis 0,2 mol Cu bzw. 0,09 mol Zinn/l und sogar darüber hinaus) war eine sichere Lötfähigkeit gegeben, d. h. 100 % der Löcher der Platte waren korrekt benetzt und durchgestiegen.

**Patentansprüche**

1. Chemische Verbindungen von intrinsisch leifähigen Polymeren mit Metallen, **dadurch gekennzeichnet, daß** das Metall Eisen, Kupfer, Magnesium, Cadmium oder Zinn ist und daß die Verbindungen erhältlich sind, indem

   (a) eine Dispersion von Polyanilin mit dem ausgewählten Metall in elementarer Form in Kontakt gebracht wird, wobei
   (b) das Dispersionsmedium bewegt wird, um einen Stoffaustausch an der Grenzfläche zwischen Metall und Dispersion zu gewährleisten, und
   (c) die Dispersion so lange mit dem Metall in Kontakt gebracht wird, bis sich die Metall-Polyanilin-Verbindung gebildet hat.

2. Verbindungen nach Anspruch 1, **dadurch gekennzeichnet, daß** sie der folgenden allgemeinen Formel I entsprechen

$$[\ (DU)_{a\cdot x}\ (Me^{a+})_x\ (DU_{ox}\ H^+)_y\ ]\ (a\cdot x+y)\ A^- \qquad (I)$$

wobei

| | |
|---|---|
| DU = | eine Dimereinheit des Polyanilins, |
| $DU_{ox}$ = | eine oxidierte Form der Dimereinheit, |
| $Me^{a+}$ = | ein Metallion der Wertigkeit a, |
| a = | die Wertigkeit des Metallions, |
| x = | eine ganze Zahl von 1 bis 10.000, |
| y = | eine ganze Zahl von 0 bis 10.000, und |
| $A^-$ = | ein Anion |

bedeutet.

**3.** Verbindungen nach einem der Ansprüche 1 oder 2, **dadurch gekennzeichnet, daß** sie den folgenden allgemeinen Formeln II oder III entsprechen

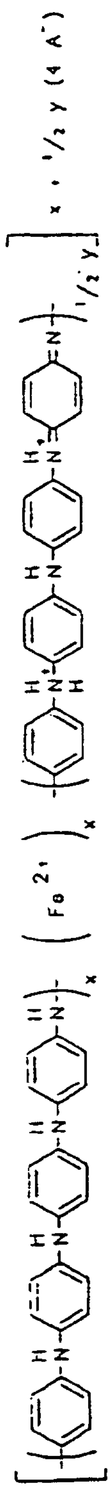

(II)

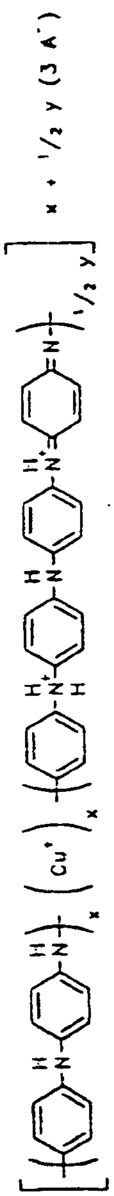

(III)

4. Verbindungen nach einem der Ansprüche 1 bis 3, **dadurch gekennzeichnet, daß** sie in Form von Dispersionen in wäßrigen oder organischen Dispersionsmitteln oder in Form von sie enthaltenden Lacken oder Polymerblends vorliegen.

5. Verbindungen nach einem der Ansprüche 1 bis 4, **dadurch gekennzeichnet, daß** es Verbindungen von Polyanilin mit Kupfer oder Eisen sind, die als Dispersionen in N-Methylpyrrolidon und iso-Propanol bei spektroskopischer Untersuchung im UV-VIS-NIR-Bereich Absorptionsmaxima bei Wellenlängen von

- Kupfer-Polyanilin-Verbindung : 285 ± 5 nm,
- Eisen-Polyanilin-Verbindung : 280 ± 5 nm,

haben.

**6.** Verfahren zur Herstellung der Verbindungen gemäß einem der Ansprüche 1 bis 5, **dadurch gekennzeichnet, daß**

(a) eine Dispersion von Polyanilin mit dem ausgewählten Metall in elementarer Form in Kontakt gebracht wird, wobei
(b) das Dispersionsmedium bewegt wird, um einen Stoffaustausch an der Grenzfläche zwischen Metall und Dispersion zu gewährleisten, und
(c) die Dispersion so lange mit dem Metall in Kontakt gebracht wird, bis sich die Metall-Polyanilin-Verbindung gebildet hat.

**7.** Verfahren nach Anspruch 6, **dadurch gekennzeichnet, daß** in (b) das Dispersionsmedium gerührt wird oder an dem Metall vorbeiströmt.

**8.** Verfahren nach Anspruch 6 oder 7, **dadurch gekennzeichnet, daß** in (c) die Dispersion für eine Dauer von 0,1 bis 10.000 min mit dem Metall in Kontakt gebracht wird.

**9.** Verwendung der Verbindungen gemäß einem der Ansprüche 1 bis 5 bei der Metallisierung von Substraten, bei der Herstellung von elektrischen Leiterplatten oder beim Schutz metallischer Gegenstände vor Korrosion.

## Claims

**1.** Chemical compounds of intrinsically conductive polymers with metals **characterized in that** the metal is iron, copper, magnesium, cadmium or tin and that the compounds are obtainable by

(a) contacting a dispersion of polyaniline with the choosen metal in an elemental form,

(b) agitating the dispersion medium in order to ensure exchange of matter at the interface between the metal and dispersion, and

(c) maintaining the dispersion in contact with the metal until the polyaniline compound has formed.

**2.** Compounds according to claim 1, **characterized in that** they correspond to the following general formula I

$$[\ (DU)_{a\cdot x}\ (Me^{a+})_x\ (DU_{ox}\ H^+)_y\ ]\ (a\cdot x+y)\ A^-$$

whereas

DU = a dimer unit of polyaniline,
$DU_{ox}$ = an oxidized form of the dimer unit,
$Me^{a+}$ = a metal ion of valency a,
a = the valency of the metal ion,
x = an integer from 1 to 10,000,
y = an integer from 0 to 10,000,
$A^-$ = an anion.

**3.** Compounds according to anyone of claims 1 or 2, **characterized in that** they correspond to the following general formulae II or III

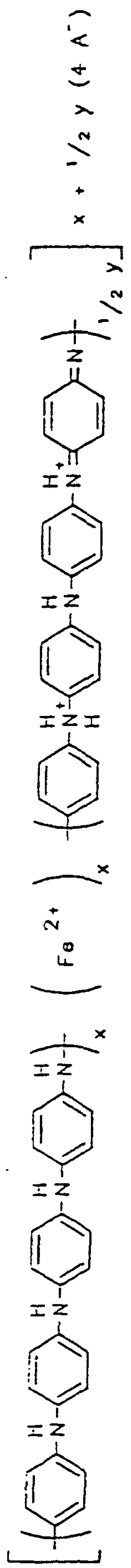

(II)

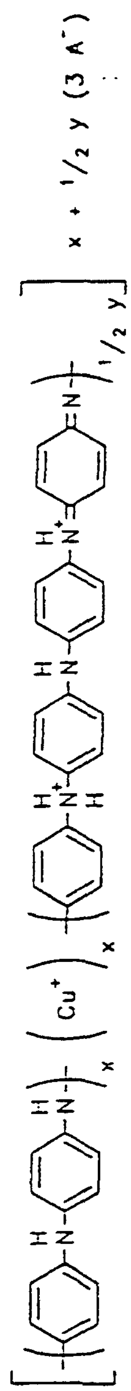

(III)

**4.** Compounds according to anyone of claims 1 to 3, **characterized in that** they are present in form of dispersions in aqueous or organic dispersion agents or in form of polymer blends containing said compounds.

**5.** Compounds according to anyone of claims 1 to 4, **characterized in that** they are compounds of polyaniline with copper or iron which, as dispersions in methylpyrrolidone and isopropanol, on spectroscopic analysis in the UV-VIS-NIR range, have absorption maxima at wave lengths of

- copper-polyaniline compound: 285 +/- 5 nm,
- iron-polyaniline compound: 280 +/- 5 nm.

**6.** Process for the preparation of compounds according to anyone of claims 1 to 5, **characterized in that**

(a) a dispersion of polyaniline is contacted with the choosen metal in an elemental form,

(b) the dispersion medium is agitated in order to ensure exchange of matter at the interface between the metal and dispersion, and

(c) the dispersion is maintained in contact with the metal until the polyaniline compound has formed.

**7.** Process according to claim 6, **characterized in that** in (b) the dispersion agent is stirred or flows past the metal.

**8.** Process according to anyone of claim 6 or claim 7, **characterized in that** in (c) maintaining the dispersion in contact with the metal for a period of between 0.1 and 10,000 minutes.

**9.** The use of the compounds according to anyone of claims 1 to 5 in the metallization of substrates, preparation of printed circuit boards or in the corrosion protection of metallic articles.

**Revendications**

**1.** Combinaisons chimiques de polymères intrinsèquement conducteurs avec des métaux, **caractérisées en ce que** le métal est du fer, du cuivre, du magnésium, du cadmium ou de l'étain et **en ce que** les combinaisons sont susceptibles d'être obtenues en

(a) mettant en contact une dispersion de polyaniline avec le métal choisi sous forme élémentaire, étant entendu que
(b) le milieu de dispersion est agité pour garantir un transfert de matière à l'interface entre le métal et la dispersion, et
(c) la dispersion est mise en contact avec le métal aussi longtemps que nécessaire pour que le composé métal-polyaniline ce soit formé.

**2.** Combinaisons selon la revendication 1, **caractérisées en ce qu'**elles répondent à la formule générale I suivante

$$[(DU)_{a.x}(Me^{a+})_x(DU_{ox}H^+)_y](a.x+y)A^- \qquad (I)$$

dans laquelle les symboles employés ont les significations suivantes :

DU = une unité dimère du polyaniline
$DU_{ox}$ = une forme oxydée de l'unité dimère
$Me^{a+}$ = un ion métallique de valence a,
a = la valence de l'ion métallique,
x = un nombre entier de 1 à 10 000,
y = un nombre entier de 0 à 10 000, et
$A^-$ = un anion.

**3.** Combinaisons selon l'une des revendications 1 ou 2, **caractérisées en ce qu'**elles répondent aux formules générales II ou III suivantes

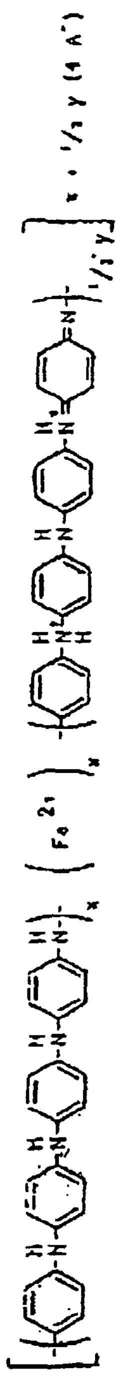

(II)

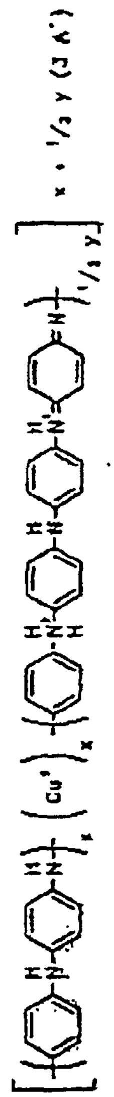

(III)

4. Composés selon l'une des revendications 1 à 3, **caractérisées en ce qu'**elles se présentent sous forme de dispersions en milieu de dispersion aqueux ou organique ou sous forme de mélanges polymères ou vernis contenant ceux-ci.

5. Composés selon l'une des revendications 1 à 4, **caractérisés en ce que** ce sont des composés de polyaniline avec du cuivre ou du fer, qui ont dans les analyses spectroscopiques en tant que dispersions dans le N-méthylpyrrolidone et l'isopropanol des maxima d'absorption dans le domaine UV-VIS-NIR à des longueurs d'ondes de

- composé cuivre-polyaniline : 285 + 5 nm,
- composé fer-polyaniline : 280 + 5 nm.

**6.** Procédé de production de composés selon l'une des revendications 1 à 5, **caractérisé en ce que**

(a) une dispersion de polyaniline est mise en contact avec le métal choisi sous forme élémentaire, étant entendu que
(b) le milieu de dispersion est agité pour garantir un transfert de matière à l'interface entre le métal et la dispersion, et
(c) la dispersion est mise en contact avec le métal aussi longtemps que nécessaire pour que le composé métal-polyaniline ce soit formé.

**7.** Procédé selon la revendication 6, **caractérisé en ce que** dans (b) le milieu de dispersion est agité ou s'écoule près du métal.

**8.** Procédé selon la revendication 6 ou 7, **caractérisé en ce que** dans (c) la dispersion est mise en contact avec le métal pour une durée de 0,1 à 10 000 min.

**9.** Utilisation des composés selon l'une des revendications 1 à 5 pour la métallisation de substrat, pour la fabrication de circuits imprimés électriques ou pour la protection d'objets métalliques contre la corrosion.

FIGUR 1

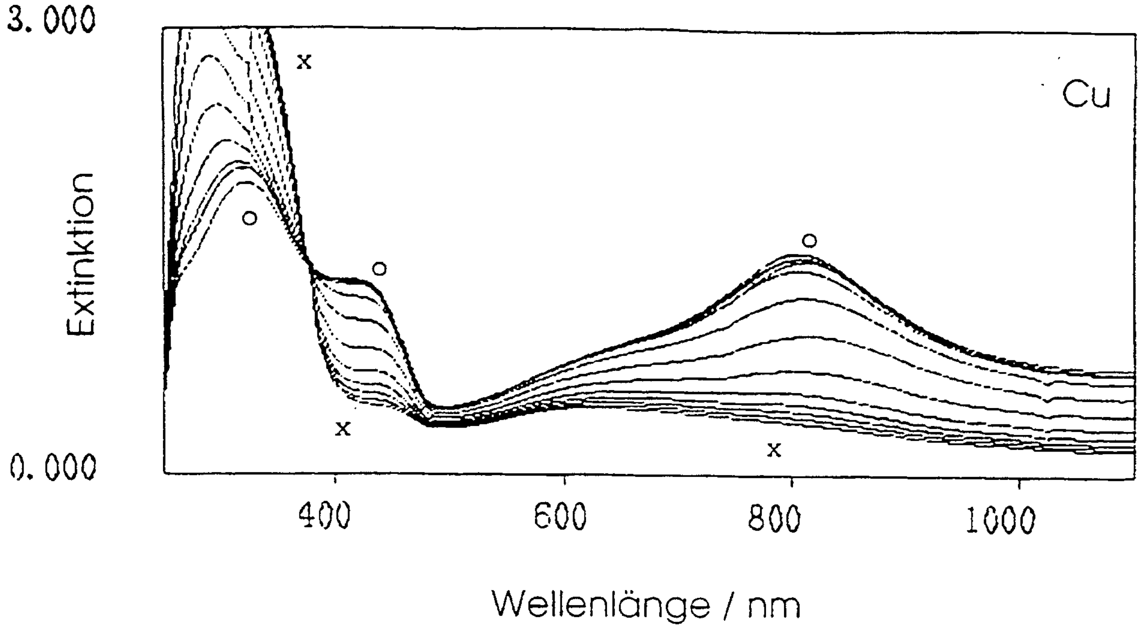


FIGUR 2

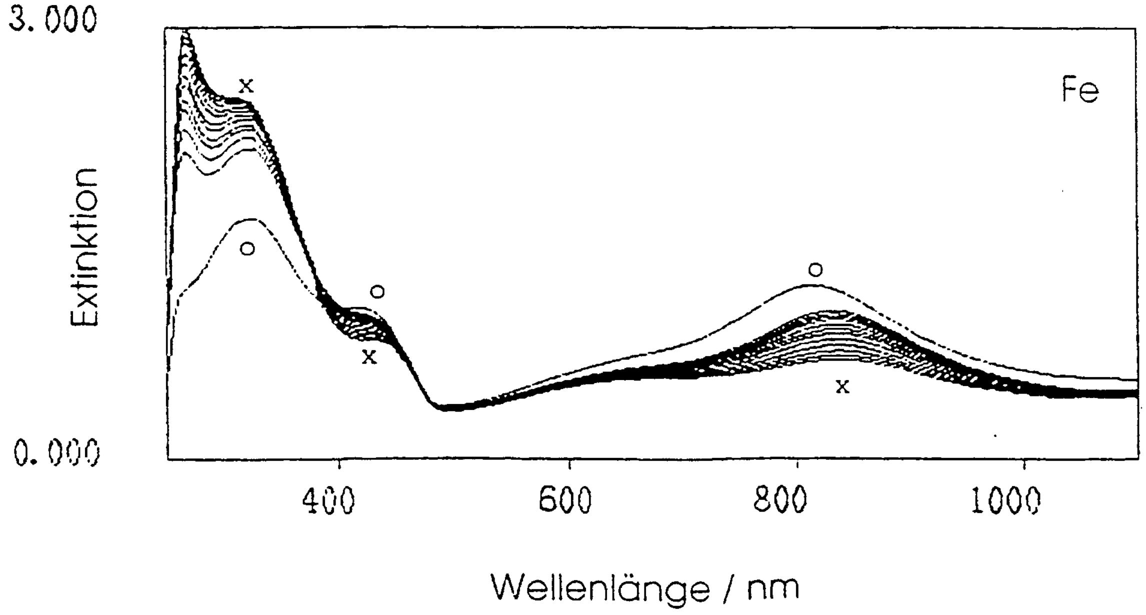

FIGUR 3

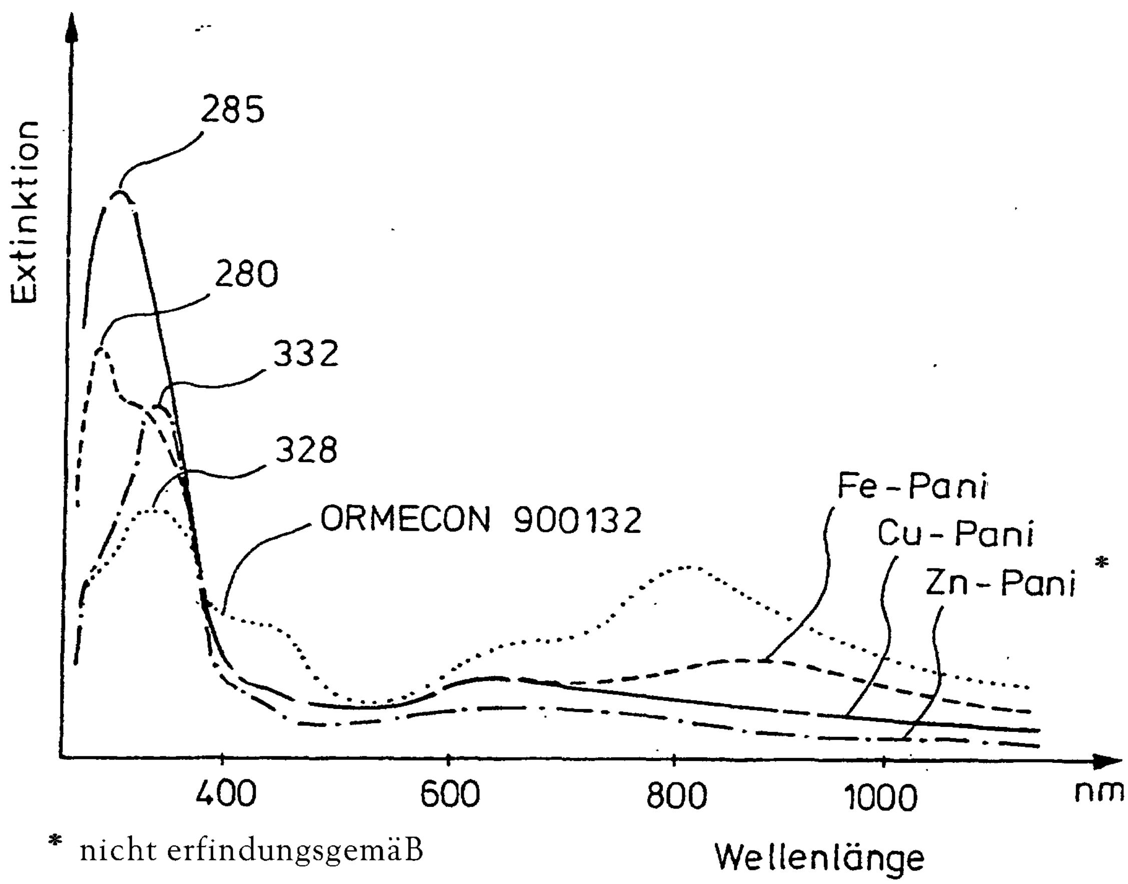


* nicht erfindungsgemäß

FIGUR 4

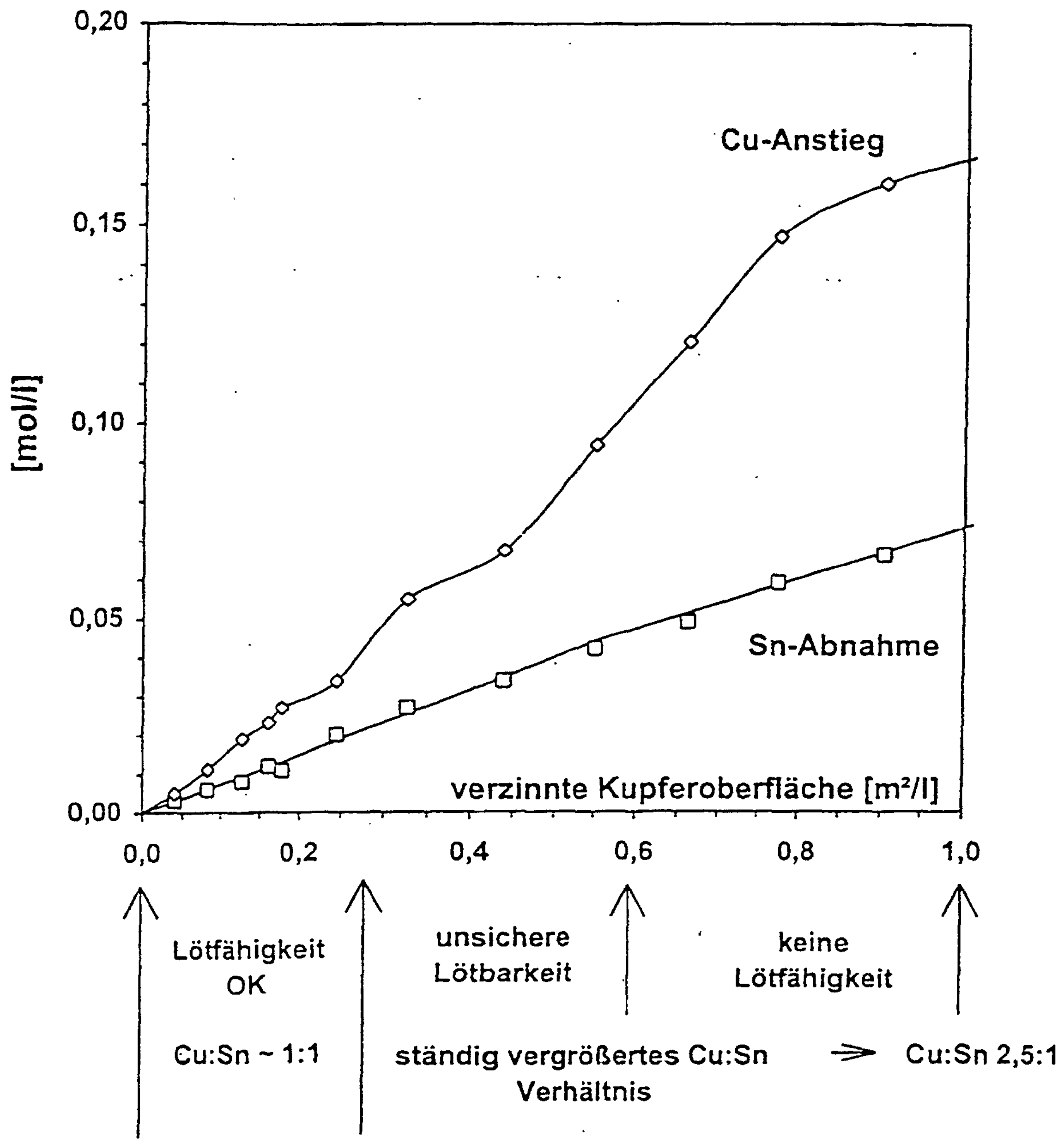
0,20
0,15
0,10
0,05
0,00
[mol/l]
Cu-Anstieg
Sn-Abnahme
verzinnte Kupferoberfläche [m²/l]
0,0
0,2
0,4
0,6
0,8
1,0
Lötfähigkeit OK
unsichere Lötbarkeit
keine Lötfähigkeit
Cu:Sn ~ 1:1
ständig vergrößertes Cu:Sn Verhältnis
Cu:Sn 2,5:1

FIGUR 5

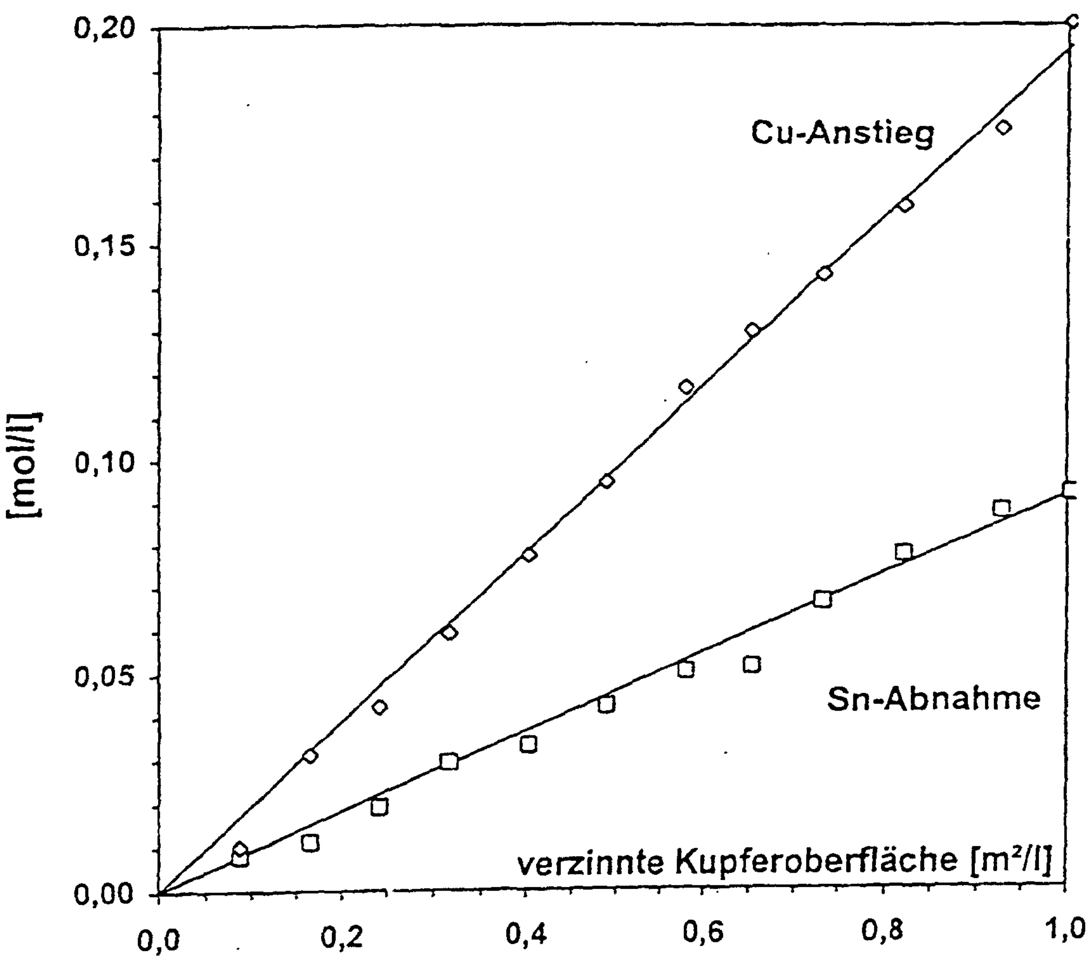


kontinuierlich lötfähig bis 1,2 m²

praktisch linear Cu:Sn = 2,2 :1